Europäisches Patentamt

European Patent Office

Office européen des brevets

(11) Veröffentlichungsnummer: **0 309 784**
**A1**

(12) **EUROPÄISCHE PATENTANMELDUNG**

(21) Anmeldenummer: 88114537.9

(22) Anmeldetag: 06.09.88

(51) Int. Cl.4: **H01L 29/52 , H01L 29/60 , H01L 29/06**

(30) Priorität: 30.09.87 DE 3733022
29.07.88 DE 3825893

(43) Veröffentlichungstag der Anmeldung:
05.04.89 Patentblatt 89/14

(84) Benannte Vertragsstaaten:
DE FR GB IT

(71) Anmelder: **Siemens Aktiengesellschaft Berlin und München**
**Wittelsbacherplatz 2**
**D-8000 München 2(DE)**

(72) Erfinder: **Dathe, Joachim, Dipl.-Phys.**
**Schleissheimer Strasse 276**
**D-8000 München 40(DE)**
Erfinder: **Reichert, Hansjörg, Dr., Dipl.-Phys.**
**Weissenseestrasse 83**
**D-8000 München 90(DE)**
Erfinder: **Scharf, Ludwig, Dipl.-Phys.**
**Montgelasstrasse 33**
**D-8000 München 80(DE)**

(54) **Anschlussstreifenstruktur für Bipolar-Transistoren.**

(57) Eine Anschlußstreifenstruktur für Bipolar-Transistoren, bei der im Basisbereich (A) Anschlußstreifen (E, B) angeordnet sind, soll so geändert werden, daß die Rückwirkungskapazität und/oder der Basis-Bahnwiderstand verringert wird. Wenigstens ein Anschlußstreifen (E, B) reicht in mindestens einer Richtung über die Isolationsberandung, die den Basisbereich (A) begrenzt, hinweg.

FIG 3

EP 0 309 784 A1

## Anschlußstreifenstruktur für Bipolar-Transistoren

Die Erfindung betrifft eine Anschlußstreifenstruktur für Bipolar-Transistoren nach dem Oberbegriff des Anspruchs 1.

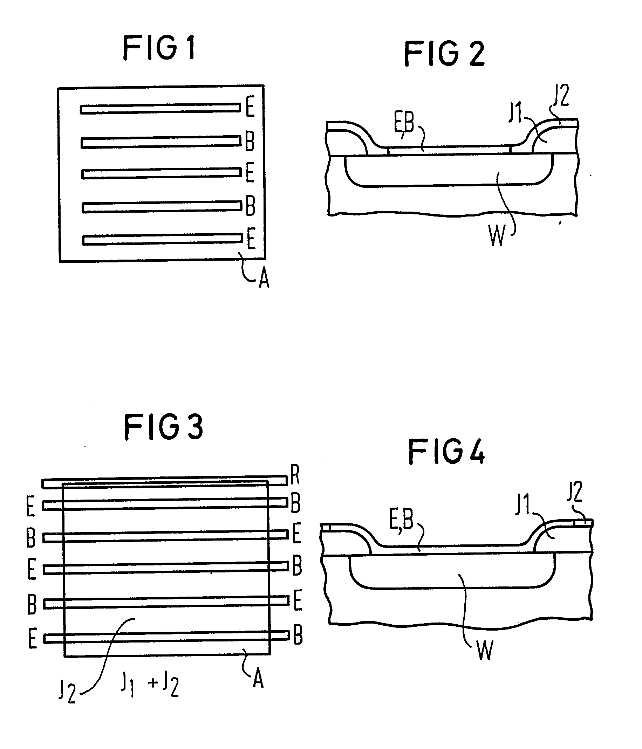

FIG 1 zeigt eine Anschlußstreifenstruktur für Bipolar-Transistoren nach dem Stand der Technik, bei der im Basisbereich A Emitter-Anschlußstreifen E und Basis-Anschlußstreifen B angeordnet sind.

FIG 2 zeigt eine Basiswanne W, über der sich eine erste Isolierschicht I1 befindet. Über der ersten Isolierschicht I1 befindet sich eine zweite Isolierschicht I2. Bisher wurde die sich über der Basiswanne W befindende Isolierschicht I1, I2 dergestalt mit Streifen für die Emitter-Anschlüsse E und für die Basis-Anschlüsse B versehen, daß die Streifen in voller Länge innerhalb des Basisbereichs A angeordnet waren.

Der vorliegenden Erfindung liegt die Aufgabe zugrunde, die eingangs genannte Anschlußstreifenstruktur für Bipolar-Transistoren so zu ändern, daß die Rückwirkungskapazität, die von den Emitterstreifen beeinflußt wird, und/oder der Basis-Bahnwiderstand,der von den Basisstreifen beeinflußt wird, verringert wird.

Diese Aufgabe wird erfindungsgemäß durch eine Anschlußstreifenstruktur nach dem Anspruch 1 gelöst.

Ausgestaltungen und Vorteile der Erfindung sind in den Unteransprüchen, der Beschreibung und der Zeichnung angegeben.

Erfindungsgemäß wird mindestens ein Streifen für mindestens einen Basis-Anschluß und/oder für mindestens einen Emitter-Anschluß so verlängert, daß der mindestens eine Streifen über die Isolation, die die Basiswanne begrenzt, hinwegreicht.

Die Erfindung ermöglicht einen Gewinn an Hochfrequenz-Qualität. Je kleiner das betreffende Bauelement ist, desto größer ist der Gewinn an Hochfrequenz-Qualität. Bei ansonsten vergleichbarer Technologieausführung ermöglicht die Erfindung einen Gewinn an Frequenzqualität von 15 bis 20 %. Dies bedeutet, daß die Hochfrequenz-Güte, die eine Funktion der bei einem bestimmten Bauelement möglichen maximalen Schwingfrequenz ist, um 15 bis 20 % gesteigert ist.

Die Aussteuerbarkeit eines Bauelements ist eine Funktion der Gesamt-Emitterfläche. Bei gleicher Aussteuerbarkeit eines bestimmten Bauelements ist erfindungsgemäß die Basisfläche kleiner. Weil die Basisfläche aufgrund der Erfindung bei gleicher Aussteuerbarkeit kleiner gestaltet werden kann, ist erfindungsgemäß eine höhere maximalen Schwingfrequenz möglich.

Die Erfindung ermöglicht eine Verkleinerung der Basisfläche bei gleicher Aussteuerbarkeit. Dies kann dadurch erzielt werden, daß die Emitter-Anschlußstreifen in mindestens einer Richtung über die Basisfläche hinausgehen. Bei Verwendung eines Mesh-Emitters können die Emitter-Anschlußstreifen auch in zwei Richtungen über die Basisfläche hinausgehen. Die Emitter-Anschlußstreifen können über die Basisfläche in ihrer Längsrichtung hinausgehen. Am Rand der Basisfläche kann jedoch auch mindestens ein Rand-Emitter-Anschlußstreifen R in seiner Länge teilweise auf der Basisfläche aufliegen und teilweise über die Basisfläche hinausreichen.

Die Basisfläche wird an ihrem Rand durch die Kollektor-Basis-Isolation begrenzt.

Die Erfindung ermöglicht es, daß bei der Strukturierung der Anschlußstreifen mittels eines Phototechnik-Schrittes die Maske, die die Anschlußstreifen-Struktur enthält, nicht mehr bezüglich der Basisfläche justiert werden muß. Damit ermöglicht es die Erfindung, daß eine Feinstruktur von Anschlußstreifen auf der Halbleiteroberfläche ohne Justierung bezüglich der Basisfläche möglich ist. Ob ein bestimmter Anschlußstreifen ein Emitteranschlußstreifen oder ein Basisanschlußstreifen ist, wird nicht beim Phototechnik-Schritt bestimmt, sondern erst bei der an diesen Phototechnik-Schritt anschließenden Implantation der verschiedenen Anschlußstreifen.

Die Erfindung ermöglicht eine Dielektrizitäts-Isolation zwischen Emitter und Kollektor am Basisrand. Es wird eine Lösung angegeben, wie an dieser kritischen Stelle die Emitter-Kollektor-Spannungsfestigkeit verbessert werden kann, so daß die Spannungsfestigkeit des Bauelements nicht mehr durch Frühdurchbrüche an dieser Stelle reduziert wird. Wenn die Isolierschicht, die die Basisfläche begrenzt, in das Material (z. B. Silizium oder Galliumarsenit),das die aktive Fläche bildet, eingesenkt ist, ist Durchbrennen (Hot spot) an der Grenzfläche zwischen der Basiswanne und der die Basisfläche begrenzenden Isolationsschicht unwahrscheinlich. Eine solche eingesenkte Isolierschicht kann z. B. bei Silizium durch lokale Oxidation (LOCOS) erzeugt werden.

Wenn die die Basisfläche begrenzende Isolierschicht nicht in die Oberfläche des Halbleitermaterials eingesenkt ist, ist wegen der Raumladungszone zwischen Emitter und Kollektor grundsätzlich ein Kurzschluß (Punch through) möglich. Eine nicht versenkte, die Basisfläche begrenzende Isolierschicht ist jedoch dennoch dort sinnvoll, wo ein Punch through zwischen Emitter und Kollektor an der Halbleiter-Grenzfläche nicht stören würde, z. B. bei niedrigen Bestriebsspannungen.

Bei geringer Emittereindringtiefe, d.h. kleiner Stromverstärkung wird die Punch through-Gefahr noch gemildert.

Die Erfindung wird anhand der Zeichnung näher erläutert.

FIG 1 und 2 zeigen schematisch eine Draufsicht und einen Schnitt durch eine Anschlußstreifenstruktur bei Bipolar-Transistoren nach dem Stand der Technik.

FIG 3 und 4 zeigen eine Draufsicht und einen Schnitt durch eine erfindungsgemäße Anschlußstreifenstruktur bei Bipolar-Transis toren.

FIG 5 bis 12 zeigen schematisch weitere Schnitte durch eine Anschlußstreifenstrukturen bei Bipolar-Transistoren.

FIG 3 zeigt eine erfindungsgemäße Anschlußstreifenstruktur von Emitteranschlußstreifen E und Basisanschlußstreifen B in der Draufsicht auf eine Basisfläche A bei Bipolar-Transistoren in Planartechnik mit Fingerstruktur. Eine Anschlußstreifenstruktur nach FIG 3 ermöglicht eine Selbstjustierung der zur Strukturierung benötigten Phototechnik in Richtung parallel zu den Anschlußstreifen E, B. Die Anschlußstreifen E, B sind so verlängert, daß sie über die Isolationsschicht I1, die die Basiswanne begrenzt, hinwegreichen.

In Richtung längs der Anschlußsstreifen E, B ist keine Justiertoleranz zu berücksichtigen. Quer dazu ergibt sich gegenüber der konventionellen Lösung eine wesentlich größere Justiertoleranz. Bei Strukturen, bei denen z. B. wegen der großen Streifenzahl das Fehlen eines Basisstreifens tolerierbar ist, ist auch in Querrichtung eine Justierung nicht mehr nötig.

FIG 4 zeigt einen Schnitt durch einen Anschlußstreifen nach FIG 3. Die Basisfläche wird von der Isolierschicht I1 begrenzt. Über der Basisfläche und der Justierschicht I1 liegt die Isolierschicht I2. In die Isolierschicht I2 sind die Streifen E, B gemäß FIG 3 eingeätzt. Die Isolierschichten I1 und I2 können auch jeweils Mehrfachschichten sein, z.B. eine Sandwichstruktur aus Oxid, Phosphorglas und/oder Nitrid aufweisen.

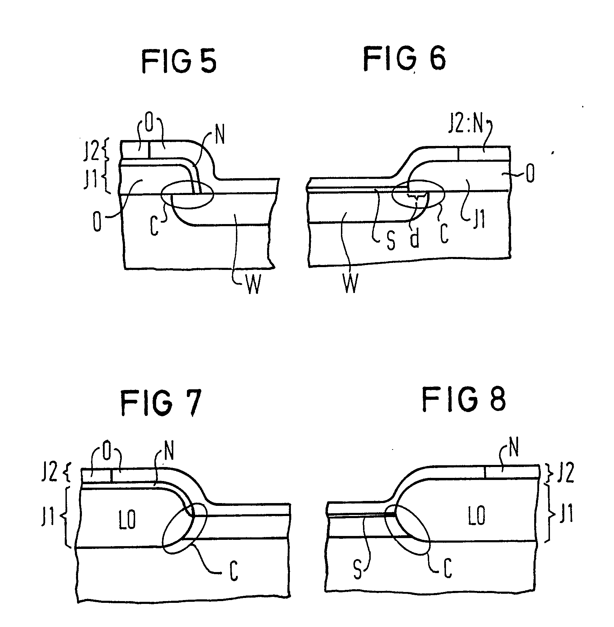

FIG 5 und 6 zeigen weitere mögliche Schritte durch eine Anschlußstreifenstruktur nach FIG 3. In der FIG 5 besteht die erste Isolierschicht I1 aus einem Sandwich Oxid O/Nitrid N und die zweite Isolierschicht aus Oxid O. In der FIG 6 ist I1 ein Oxid O und I2 ein Nitrid N, das gegebenenfalls im Basisbereich noch mit einem dünnen Oxid, z.B. dem Streuoxid S von der Basisimplantation unter lagert sein kann. In beiden Fällen ist die stark unterschiedliche Ätzbarkeit Oxid/Nitrid hilfreich. Damit kann sicher eine Einätzung an den kritischen Stellen C verhindert werden.

In FIG 4 bis 6 ragt die erste Isolierschicht I1 jeweils über den Rand der Basiswanne W hinaus in die Basisfläche A hinein (Unterdiffusion bei der Basiserzeugung), damit hier ein Kurzschluß zwischen Emitter und Basis erschwert wird.

FIG 7 und 8 zeigen weitere mögliche Schnitte durch FIG 3. Die erste Isolierschicht I1 besteht dabei aus einem in die Halbleiteroberfläche eingesenkten LOCOS-Oxid LO, das analog FIG 5 selbstjustierend mit Nitrid N bedeckt sein kann. Diese Selbstjustierung wird z.B. durch anodische Oxidation des Nitrids im Basisbereich A erreicht. Es ergibt sich der gleiche prinzipielle Aufbau wie in FIG 5 und 6. Wegen der Mesa-Form der Basis ist die Punch through - Neigung an Stellen A unterdrückt. Der Schichtenaufbau bei den FIG 7 und 8 entspricht im übrigen dem Schichtenaufbau bei den FIG 5 und 6.

Wenn die die Basisfläche A begrenzende Isolierschicht I1 nicht in die Oberfläche eingesenkt ist und die Punch through - Festigkeit an den kritischen Stellen C analog FIG 5 und 6 nicht ausreichend ist, kann durch einen zusätzlichen Spacer ein Punch through an den Stellen C verhindert werden, d.h. es wird die volle Spannungsfestigkeit wie bei einer konventionellen Konstruktion erreicht.

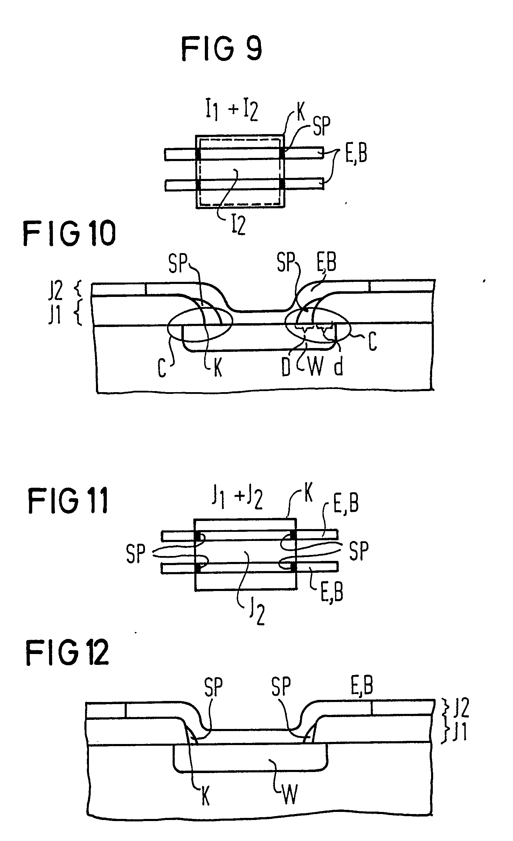

Es gibt dabei zwei Möglichkeiten der Spacer-Erzeugung. Die erste ist in FIG 9 und 10 dargestellt. Hier wird der Spacer SP nach der Strukturierung der Isolierschicht I1 und der Einbringung der Basisdotierung erzeugt. Der Spacer SP verläuft dabei längs der Basiskante K. Die Bezeichnung ist im folgenden Spacer I. Die Herstellung eines Spacers ist mehrfach beschrieben, z.B. in der Patentanmeldung EP-A-0 135 408. Einen Spacer wie in FIG 9 und 10 erhält man, wenn man nach der Basisdotierung die Halbleiterscheibe mit einem CVD-Oxid beschichtet. Diese Schicht wird senkrecht zur Oberfläche gerichtet (RIE-Ätzung) abgeätzt. Dabei verbleibt längs der Kante K der Isolierschicht I1 ein Oxidsaum, nämlich der Spacer SP nach der Aufsicht von FIG 9 stehen. Nach dem Aufbringen der Isolierschicht I2 und der Streifenätzung ergibt sich ein Schnittbild durch einen Streifen nach FIG 10. Der kritische Abstand d ist dabei gegenüber FIG 5 um die Spacerdicke D vergrößert.

Die zweite Möglichkeit, einen Spacer SP an den kritischen Stellen C zu erhalten, erfordert keine zusätzlichen Prozesse. Bei der gleichen Prozeßfolge, die zum Ergebnis nach FIG 5 und 6 führt, wird lediglich die Einätzung der Streifen E, B durch eine gerichtete Ätzung, z.B. RIE-Ätzung, vorgenommen. In diesem Falle entstehen nur Spacerstücke im Streifenbereich an der Basiskante, aber damit genau an der Stelle, wo es gilt, den seitlichen Punch through zu verhindern. Dieser Spacer SP wird im folgenden Text mit Spacer I1 bezeichnet (Veranschaulichung in FIG 11 und 12).

Spacer I und Spacer II werden technologisch voneinander unabhängig hergestellt. Sie können daher miteinander kombiniert werden. Es addieren sich dabei in erster Näherung an den entscheidenden Stellen C die Spacerdicken. Ein solcher Doppel-Spacer ist dann vorteilhaft, wenn aus anderen Gründen nur dünne Schichten verwendet werden können.

## Ansprüche

1. Anschlußstreifenstruktur für Bipolar-Transistoren. bei der im Basisbereich (A) Anschlußstreifen (E,B) angeordnet sind, **dadurch gekennzeichnet,** daß wenigstens ein Anschlußstreifen (E,B) in mindestens einer Richtung über die Isolationsberandung, die den Basisbereich (A) begrenzt, hinwegreicht.

2. Anschlußstreifenstruktur nach Anspruch 1, **dadurch gekennzeichnet,** daß mindestens ein Anschlußstreifen (E,B) in seiner Längsrichtung über die Isolationsberandung, die den Basisbereich (A) begrenzt. hinausreicht.

3. Anschlußstreifenstruktur nach Anspruch 1 oder 2, **dadurch gekennzeichnet,** daß wenigstens ein Rand-Anschlußstreifen (R) in seiner Länge über die Isolationsberandung, die den Basisbereich (A) begrenzt, hinausreicht.

4. Anschlußstreifenstruktur nach einem der Ansprüche 1 bis 3, d **dadurch gekennzeichnet,** daß wenigstens ein Emitter-Anschlußstreifen (E) über die Isolationsberandung, die den Basisbereich (A) begrenzt. hinausreicht.

5. Anschlußstreifenstruktur nach einem der Ansprüche 1 bis 4, **dadurch gekennzeichnet,** daß wenigstens ein Basis-Anschlußstreifen (B) über die Isolationsberandung, die den Basisbereich (A) begrenzt, hinausreicht.

6. Anschlußstreifenstruktur nach einem der Ansprüche 1 bis 5, **dadurch gekennzeichnet,** daß die Isolationsberandung, die den Basisbereich (A) begrenzt, eine eingesenkte Isolationsschicht (LO) berandet.

7. Anschlußstreifenstruktur nach einem der Ansprüche 1 bis 6, **dadurch gekennzeichnet,** daß der Abstand zwischen Emitter (E) und Kollektor (K) durch einen zusätzlichen Abstand (S) vergrößert ist.

FIG 1

FIG 2

FIG 3

FIG 4

FIG 5

FIG 6

FIG 7

FIG 8

FIG 9

FIG 10

FIG 11

FIG 12

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-3 475 665 (G.W. McIVER) * Spalte 2, Zeile 62 - Spalte 3, Zeile 59; Figur 1 * --- | 1,2,4,5 | H 01 L 29/52 H 01 L 29/60 H 01 L 29/06 |
| X | FR-A-2 392 500 (N.V. PHILIPS' GLOEILAMPENFABRIEKEN) * Figur 2 * --- | 1 | |
| A | WO-A-8 203 949 (R. BOSCH GmbH) * Zusammenfassung; Figuren 1,2 * --- | 1,2,4,5 | |
| A | US-A-4 644 383 (AKCASU) * Figur 3 * --- | 1,2,5,6 | |
| A | ELECTRONICS, Band 41, Nr. 23, 11. November 1968, Seiten 53-54; "High-voltage IC's" * Seite 53; Figuren * ----- | 1,2,4,7 | |

RECHERCHIERTE SACHGEBIETE (Int. Cl.4)

H 01 L

Der vorliegende Recherchenbericht wurde für alle Patentansprüche erstellt

| Recherchenort | Abschlußdatum der Recherche | Prüfer |
|---|---|---|
| DEN HAAG | 09-01-1989 | BAILLET B.J.R. |